(19) Europäisches Patentamt / European Patent Office / Office européen des brevets

(11) **EP 2 733 132 B1**

(12) **EUROPEAN PATENT SPECIFICATION**

(45) Date of publication and mention
of the grant of the patent:
**28.12.2016 Bulletin 2016/52**

(51) Int Cl.:
*C04B 35/581* (2006.01)    *C04B 35/638* (2006.01)
*C04B 35/645* (2006.01)    *H01L 23/373* (2006.01)

(21) Application number: **12811767.8**

(22) Date of filing: **04.07.2012**

(86) International application number:
**PCT/JP2012/067100**

(87) International publication number:
**WO 2013/008697 (17.01.2013 Gazette 2013/03)**

(54) **ALN SUBSTRATE AND METHOD FOR PRODUCING SAME**

ALN-SUBSTRAT UND HERSTELLUNGSVERFAHREN DAFÜR

SUBSTRAT D'ALN ET SON PROCÉDÉ DE FABRICATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **14.07.2011 JP 2011155856**

(43) Date of publication of application:
**21.05.2014 Bulletin 2014/21**

(73) Proprietor: **A.L.M.T. Corp.**
**Minato-ku**
**Tokyo 105-0014 (JP)**

(72) Inventors:
• **YAMAMOTO, Takehisa**
**Itami-shi**
**Hyogo 664-0016 (JP)**

• **ISHIDU, Sadamu**
**Itami-shi**
**Hyogo 664-0016 (JP)**

(74) Representative: **Boult Wade Tennant**
**Verulam Gardens**
**70 Gray's Inn Road**
**London WC1X 8BT (GB)**

(56) References cited:
**JP-A- 2 279 568**    **JP-A- H0 925 186**
**JP-A- 11 217 269**    **JP-A- H03 193 670**
**JP-A- 2005 001 975**    **JP-A- 2005 179 167**
**JP-A- 2006 282 500**    **JP-A- 2008 300 562**
**US-A- 4 803 183**    **US-A1- 2006 035 107**

EP 2 733 132 B1

**Description**

Technical Field

The present invention relates to an AlN substrate and a method for producing the AlN substrate.

Background Art

To remove heat from a semiconductor device, such as a semiconductor light-emitting device, that is accompanied by heat generation during operation, a heat spreader made of a material that has high thermal conductivity is used.
For example, a base substrate that is a component of a laminated substrate formed by sticking the base substrate and a semiconductor substrate together can be mentioned as the heat spreader (see Patent Literature 1, etc.).
In the laminated substrate, a single-layered or multi-layered semiconductor layer is epitaxially grown on an exposed surface on the semiconductor substrate side, and, as a result, a semiconductor device, such as the aforementioned semiconductor light-emitting device, is formed.
The base substrate is required to have high thermal conductivity as mentioned above, and is also required to have a small difference in thermal expansion coefficient between the base substrate and the semiconductor substrate in order to prevent the laminated substrate from curving or peeling off. For example, an AlN substrate that satisfies these requirements is suitably used as the base substrate if a substrate made of GaN etc., is used as the semiconductor substrate.
However, as disclosed by Patent Literature 2, many defects (pores) are present inside a conventional AlN substrate that is produced by sintering AlN (aluminum nitride), and, if a bonding surface to be bonded to the semiconductor substrate is subjected to, for example, mirror polishing in order to improve the efficiency of heat transfer, the pore will be opened, and there is a possibility that a desired heat transfer effect cannot be obtained because the pore appears on the bonding surface in the form of a void that obstructs heat transfer between the base substrate and the semiconductor substrate.
Therefore, a problem resides in the fact that, in the laminated substrate that includes the conventional AlN substrate serving as a base substrate, heat from the semiconductor device formed on the semiconductor substrate cannot be removed by being efficiently transferred from the semiconductor substrate to the AlN substrate, and this heat easily causes the malfunction or the breakdown of the semiconductor device. JP2008 300562A relates to a group III nitride semiconductor layer stuck substrate and semiconductor device. JPH02279568A relates to an aluminium nitride sintered body and its production.
JP2006282500A discloses sintered AlN bodies with a smooth surface. AlN bodies have been made by using HIP, adding either 0.01 wt% of $CaCO_3$, leading to a Ra of 31 nm or adding 3.3 wt% of yttria, leading to a Ra of 26 nm. Sintered AlN containing both 5 wt% yttria and 0.5 wt% $CaCO_3$ is also disclosed.
JP2005001975A discloses a sintered AlN ceramic containing 5 wt% of yttria with an Ra of 8 nm. CaO can also be used as sintering aid.
US4803183A discloses sintering AlN ceramics using HIP at 100-400 MPa.
JPH0925186A discloses a sintered AlN substrate made by sinterforging at 1800°C and 9.8 MPa. It contains 0.9 wt% yttria and 0.02 wt% of calcium oxide as sintering aids. It has been polished to a surface roughness of 10 nm. The depth of the pores is 4.7 microns, whereas the ratio of the length to the depth of the pores is 7.1. This means that the length of the pores is at least 23.5 microns.

Citation List

Patent Literature

Patent Literature 1: Japanese Unexamined Patent Publication No. 2008-300562
Patent Literature 2: Japanese Unexamined Patent Publication No. 2002-293637

Summary of Invention

Technical Problem

An object of the present invention is to.provide an AlN substrate superior to a conventional one in the efficiency of heat transfer between the AlN substrate and another member, such as a semiconductor substrate, that is bonded to a bonding surface, and to provide a method for producing the AlN substrate. Solution to Problem

The present invention provides an AlN substrate according to claim 1.

The AlN substrate of the present invention consists of a sintered body of AlN including a group 2A element and a group 3A element as mentioned above, and has a smooth surface serving as a bonding surface that includes voids small in number and whose surface roughness Ra is 15 nm or less, and, in voids that are present on the bonding surface and whose long diameters are 0.25 $\mu$m or more, the mean value of the long diameters is set at 1.5$\mu$m or less, and the maximum value thereof is set at 1.8 $\mu$m or less, and therefore the efficiency of heat transfer between the AlN substrate and another member, such as a semiconductor substrate, that is bonded to the bonding surface can be made higher than before.

Therefore, if a laminated substrate is formed by sticking the AlN substrate of the present invention serving as, for example, a base substrate and a semiconductor substrate together, heat from a semiconductor device, such as a semiconductor light-emitting device, formed on the semiconductor substrate can be more efficiently transferred from the semiconductor substrate to the AlN substrate than before, and can also be removed as promptly as possible through, for example, a heat release member connected to the AlN substrate, and therefore the malfunction or breakdown of the semiconductor device caused by the heat can be reliably prevented.

Preferably, the group 2A element is at least one selected from the group consisting of Ca and Mg. The AlN substrate of the present invention includes the group 2A element at a rate of 0.009 mass% or more and 0.28 mass% or less in oxide equivalent.

Additionally, preferably, the group 3A element is at least one selected from the group consisting of Y and lanthanoids. The AlN substrate of the present invention includes the group 3A element at a rate of 0.02 mass% or more and 4.5 mass% or less in oxide equivalent.

The present invention also provides a method for producing the AlN substrate of the present invention according to claim 4.

According to the present invention, a sintered body (tentative sintered body) of AlN that has a theoretical density falling within a fixed range and that is formed by being sintered at a comparatively low temperature within the aforementioned temperature range from a precursor formed by the sintering material including each component mentioned above is subjected to HIP treatment under the aforementioned conditions, and, as a result, pores that are present inside the sintered body can be filled, and the size of each pore can be reduced in diameter, and the number of the pores can be reduced.

In other words, the group 2A element contained in the sintering material reacts with an oxide on the surface of AlN particles by heating in the aforementioned temperature range at the HIP treatment step, and functions to promote the generation of a liquidphase along with other sintering assistant components contained in the sintering material, whereas the group 3A element functions to appropriately adjust the viscosity of the liquid phase generated thereby.

Therefore, hydrostatic pressure falling within the aforementioned pressure range is applied to the whole of the sintered body at the HIP treatment step, and, as a result, the sintering assistant that has reached a semi-molten state is allowed to flow at a grain boundary part of the sintered body, and crystal grains that form the sintered body are rearranged so as to densify the sintered body, and, as a result, the number of the pores can be reduced by filling the pores present inside the sintered body as mentioned above, and the size of each of the remaining pores can be reduced.

Therefore, the bonding surface to be bonded to another member is subjected to mirror polishing etc. , after completing the HIP treatment, and, as a result, the pores are opened, and, in voids appearing on the bonding surface and having long diameters of 0.25 $\mu$m or more, the mean value of the long diameters can be set at 1.5 $\mu$m or less, and the maximum value thereof can be set at 1.8 or less, and the surface roughness Ra of the bonding surface serving as the parameter of the number of voids can be set at 15 nm or less as mentioned above.

It is conceivable that, instead of the sintering step + the HIP treatment step, (a) a hot press method in which sintering is performed while pressing a precursor is employed, (b) the sintering step is excluded, and a precursor is subjected directly to HIP treatment, or (c) the sintering step is performed at two stages under different sintering conditions, and the HIP treatment is excluded.

However, in the hot press method mentioned in (a), the movement of the sintering assistant is not performed satisfactorily, and therefore it is impossible to produce a densified AlN substrate that is equivalent to an AlN substrate produced according to the production method of the present invention.

Additionally, in the method mentioned in (b), the pore is an open pore, and therefore, likewise, it is impossible to produce a densified AlN substrate that is equivalent to an AlN substrate produced according to the production method of the present invention.

Still additionally, even if the sintering process is performed at two stages as mentioned in (c), the movement of the sintering assistant is not performed satisfactorily, and therefore it is impossible to produce a densified AlN substrate that is equivalent to an AlN substrate produced according to the production method of the present invention.

Effects of the Invention

According to the present invention, it is possible to provide an AlN substrate superior to a conventional one in the efficiency of heat transfer between the AlN substrate and another member, such as a semiconductor substrate, that is bonded to a bonding surface, and it is possible to provide a method for producing the AlN substrate.

Modes for Carrying Out the Invention

<AlN Substrate>

The present invention is an AlN substrate according to claim 1.

According to the present invention, the AlN substrate is made of an AlN sintered body including a group 2A element and a group 3A element as described above, and has a smooth surface that has only a few voids and whose bonding surface has a surface roughness Ra of 15 nm or less, and, in voids having long diameters of 0.25 $\mu$m or more that are present on the bonding surface, the mean value of the long diameters is set to be 1.5 $\mu$m or less, and the maximum value of the long diameters is set to be 1. 8$\mu$m or less, and therefore the efficiency of heat transfer between the AlN substrate and another member, such as a semiconductor substrate, that is bonded to the bonding surface can be made higher than before.

Therefore, if a laminated substrate is formed by sticking the AlN substrate of the present invention serving as, for example, a base substrate and a semiconductor substrate together, heat from a semiconductor device, such as a semiconductor light-emitting device, formed on the semiconductor substrate can be more efficiently transferred from the semiconductor substrate to the AlN substrate than before, and can also be removed as promptly as possible through, for example, a heat release member connected to the AlN substrate, and therefore the malfunction or breakdown of the semiconductor device caused by the heat can be reliably prevented.

In the present invention, the reason why the surface roughness Ra of the bonding surface is limited to 15 nm or less as mentioned above is as follows.

In detail, if the surface roughness Ra exceeds 15 nm, many voids will be present on the bonding surface even if it falls within the range of the long diameters of voids and even if the mean value of the long diameters falls within the aforementioned range, and therefore it is impossible to obtain an effect by which the efficiency of heat transfer between the AlN substrate and another member to be bonded to the bonding surface is improved. Additionally, there is also a fear that the other member will become low in the bonding strength and will easily peel off.

In consideration of further improving the effect of heightening the efficiency of heat transfer by reducing the number of voids, it is preferable to make the surface roughness Ra of the bonding surface as small as possible in the aforementioned range, and, in particular, it is preferable to set the surface roughness Ra of the bonding surface at 10 nm or less, especially at 3 nm or less. However, in consideration of the productivity or the yield of the AlN substrate, it is preferable to set the surface roughness Ra at 0.1 nm or more in the aforementioned range. It is substantially difficult to set the surface roughness Ra to be less than the aforementioned range.

In the present invention, the surface roughness Ra of the bonding surface is represented by the "arithmetical mean deviation Ra of the assessed profile" that is established in Japan Industrial Standard JIS B 0601:2001 "Geometrical Product Specifications (GPS) - Surface texture: Profile method- Terms, definitions and surface texture parameters."

Additionally, in the present invention, the reason why the long diameters of voids, which are exposed on the bonding surface and based on which the mean value and the maximum value of the long diameters are calculated, are limited to 0.25 $\mu$m or more is as follows.

In detail, many extremely small voids each of which has a long diameter less than 0.25 $\mu$m are filled when another member, such as a semiconductor substrate, is stuck to the bonding surface according to a method, such as a direct bonding method or a surface activation method, and, even if those remain in the form of voids after being stuck together, heat transfer between the AlN substrate and the other member bonded thereto will never be obstructed.

Therefore, in the present invention, small voids the long diameter of each of which is 0.25 $\mu$m or less will not be counted as voids when the mean value and the maximum value of the long diameters of voids exposed on the bonding surf ace are calculated.

Additionally, in the present invention, the reason why, in voids that are exposed on the bonding surface and that have long diameters of 0.25 $\mu$m or more, the mean value of the long diameters is limited to 1.5 $\mu$m or less, and the maximum value thereof is limited to 1.8 $\mu$m or less is as follows.

In detail, if either the mean value or the maximum value of the long diameters of the voids exposed on the bonding surface exceeds the aforementioned range, it is impossible to obtain an effect by which the efficiency of heat transfer between the AlN substrate and another member bonded to the bonding surface is improved even if the surface roughness Ra of the bonding surface falls within the range of 15 nm or less. Additionally, there is also a fear that the other member will become low in the bonding strength and will easily peel off.

Preferably, the mean value of the long diameters of the voids is 1.0 $\mu$m or less in the aforementioned range in consideration of further improving the effect of heightening the efficiency of heat transfer. Additionally, preferably, the maximum value of the long diameters of the voids is 1.2 $\mu$m or less in the aforementioned range.

However, in consideration of the productivity or the yield of the AlN substrate, it is preferable to set the mean value of the long diameters of the voids at 0.3 $\mu$m or more in the aforementioned range, and it is preferable to set the maximum value thereof at 0.5 $\mu$m or more in the aforementioned range. It is substantially difficult to set the mean value and the maximum value to be less than the aforementioned range.

In the present invention, the long diameters of the voids exposed on the bonding surface will be represented by values measured by the following method.

In detail, carbon is vapor-deposited onto a bonding surface, which has undergone mirror polishing or the like, of an AlN substrate, and five arbitrary fields of view are photographed at 1000-fold magnification by use of a scanning electron microscope. Thereafter, a photographed image is enlarged three times, and all voids confirmed in the field of view are subjected to ellipse approximation, and its long axis is measured as a long diameter. Thereafter, the mean value and the maximum value of the long diameters are found from measurement values of the long diameters of all voids having long diameters of 0.25 $\mu$m or more, excluding the voids the long diameter of each of which is less than 0.25 $\mu$m.

Preferably, at least one selected from, for example, the group consisting of Ca and Mg is used as the group 2A element. Additionally, preferably, at least one selected from, for example, the group consisting of Y and lanthanoids is used as the group 3A element.

In an AlN substrate produced by the production method of the present invention described later, the percentage of the group 2A element is 0.009 mass% or more in oxide equivalent based on the composition of a sintering material used as its starting material, and is 0.28 mass% or less. The percentage of the group 3A element is 0.02 mass% or more in oxide equivalent, and is 4.5 mass% or less.

The reason why the percentage of the group 2A element is less than the aforementioned range is that, in many cases, the percentage of the group 2A element in the sintering material used as a starting material in the production method of the present invention is smaller than the predetermined value described above. In those cases, there is a fear that an effect brought about by mixing the group 2A element with the sintering material cannot be obtained, and voids exposed on the bonding surface of the AlN substrate that has been polished will exceed the range determined in the present invention, and will become large.

On the other hand, the reason why the percentage of the group 2A element exceeds the aforementioned range is that, in many cases, the percentage of the group 2A element in the sintering material is likewise larger than the predetermined value described above, and, in those cases, there is a fear that voids exposed on the bonding surface of the AlN substrate that has been polished will likewise exceed the range determined in the present invention because of the action of excessive group 2A elements, and will become large.

The reason why the percentage of the group 3A element is less than the aforementioned range is that, in many cases, the percentage of the group 3A element in the sintering material is smaller than the predetermined value described above, and, in those cases, there is a fear that an effect brought about by mixing the group 3A element with the sintering material cannot be obtained, and voids exposed on the bonding surface of the AlN substrate that has been polished will exceed the range determined in the present invention, and will become large.

On the other hand, the reason why the percentage of the group 3A element exceeds the aforementioned range is that, in many cases, the percentage of the group 3A element in the sintering material is likewise larger than the predetermined value described above, and, in those cases, there is a fear that the thermal conductivity of an AlN substrate to be produced cannot be maintained within a suitable range of thermal conductivity required of the AlN substrate, especially within a range of 80 W/m·K or more described later.

The AlN substrate may contain Si at a rate of 0.3 mass% or less in oxide equivalent. The lower limit of the content rate of Si is 0 mass%, i.e., a case in which Si is not contained is included.

The remainder of the AlN substrate is substantially AlN. The term "substantially" mentioned here denotes that Al that is not a component of the aforementioned compound AlN, or O, or other inevitable impurities may be contained in a complex oxide that forms a grain boundary, in addition to AlN.

The content rate of each component in oxide equivalent can be found from a result obtained by analyzing the bonding surface, which has undergone mirror polishing, of the AlN substrate according to a glow discharge mass spectrometry (GDMS).

Preferably, the AlN substrate of the present invention has a thermal conductivity of 80 W/m·K or more in consideration of giving high thermal conductivity to remove heat from a semiconductor device, such as a semiconductor light-emitting device, as promptly as possible.

Preferably, the thermal conductivity is 260 W/m·K or less in the aforementioned range. Although the thermal conductivity is adjustable by appropriately changing the particle diameter of a crystal grain of AlN that is a component of an AlN sintered body, the composition of a sintering material, and so on, it is substantially difficult to form an AlN substrate that has high thermal conductivity that exceeds 260 W/m·K in an AIN sintered body.

Additionally, when a laminated substrate is created by sticking the AIN substrate of the present invention serving as a base substrate as described above onto a semiconductor substrate made of GaN etc., a difference in thermal expansion coefficient between the AIN substrate and the semiconductor substrate is required to be small. More specifically, preferably, the thermal expansion coefficient of the AIN substrate is about $3.5 \times 10^{-6}$/K or more and about $4.8 \times 10^{-6}$/K or less.

The AIN substrate of the present invention can be suitably used as a base substrate as described above in order to create a laminated substrate by sticking the semiconductor substrate and the AIN substrate together, and can also be used as an insulating substrate in which a semiconductor device or the like is directly bonded to the bonding surface.

In any case, the AIN substrate has high thermal conductivity, and is excellent in the efficiency of heat transfer between the AIN substrate and another member as described above, and therefore heat from a semiconductor device, such as a semiconductor light-emitting device, can be more efficiently transferred to the AIN substrate than before, and can also be removed as promptly as possible through a heat release member or the like that is connected to the AIN substrate, and therefore the malfunction or breakdown of the semiconductor device caused by the heat can be reliably prevented.

<Production Method of AIN Substrate>

It is possible to produce the AIN substrate of the present invention according to the production method of the present invention including a step of forming a precursor of the AIN substrate by use of a sintering material that includes AIN falling within a range of 88.7 mass% or more and 98.5 mass% or less, a group 2A element falling within a range of 0.01 mass% or more and 0.3 mass% or less in oxide equivalent, and a group 3A element falling within a range of 0.05 mass% or more and 5 mass% or less in oxide equivalent, a step (sintering step) of sintering the precursor at a temperature of from 1500°C to 1900°C so as to form a sintered body, and a step (HIP treatment step) of applying HIP treatment to the sintered body at a temperature of from 1450°C to 2000°C and under a pressure of 9.8 MPa or more.

In the present invention, various materials, such as AIN, the group 2A element, and the group 3A element mentioned above, that serve as raw materials forming an AIN substrate through the sintering step and the HIP treatment step exclusive of organic substances, such as binders or organic solvents described later, or water that are removed not later than the sintering step are generically called sintering material.

The mass% of AIN, the mass% of the group 2A element, or the mass% of the group 3A element is the content rate in the total amount of the sintering material. When two or more kinds of elements are used together as the group 2A elements and as the group 3A elements, the content rate (in oxide equivalent) of the total of the two or more kinds of elements used together is required to fall within the aforementioned range.

The reason why the content rate of AIN in the total amount of the sintering material is limited to 88.7 mass% or more and 98.5 mass% or less in the present invention is as follows.

In detail, if the content rate of AIN is less than the aforementioned range, there is a fear that the thermal conductivity of an AIN substrate produced through each step mentioned above will not be maintained within the suitable range of thermal conductivity required of the AIN substrate, particularly within the range of 80 W/m·K or more described above.

On the other hand, if it exceeds the aforementioned range, the content rate of a sintering assistant will be relatively reduced, and therefore it is impossible to obtain an effect by which a sintered body is densified by rearranging crystal grains that form the sintered body during HIP treatment, and pores that are present inside the sintered body are filled or are reduced in diameter.

Additionally, the reason why the content rate of the group 2A element in the total amount of the sintering material is limited to 0.01 mass% or more and 0.3 mass% or less in oxide equivalent is as follows.

In detail, if the content rate of the group 2A element is less than the aforementioned range, it is impossible to obtain an effect by which the generation of a liquid phase is promoted together with other sintering assistant components contained in the sintering material while reacting with an oxide on the surface of AIN particles as described above by means of the group 2A element. Therefore, low-temperature sintering is not advanced, and it is impossible to obtain an effect by which a sintered body is densified by rearranging crystal grains that form the sintered body during HIP treatment, and pores that are present inside the sintered body are filled or are reduced in diameter.

On the other hand, if it exceeds the aforementioned range, sintering is excessively advanced, and a sintering assistant is liable to segregate to the triple point of the AIN crystal grain, and, if this segregation occurs, the movement of the sintering assistant will be obstructed during HIP treatment, and therefore it is impossible to obtain an effect by which a sintered body is densified by rearranging crystal grains that form the sintered body, and pores that are present inside the sintered body are filled or are reduced in diameter.

Therefore, in any case, voids exposed on the bonding surface of the AIN substrate that has been polished exceed the range determined in the present invention, and become large.

Preferably, at least one selected from the group consisting of Ca and Mg is used as the group 2A element, and, particularly, Ca is used as the group 2A element in consideration of, for example, the aforementioned promotion effect.

Additionally, the reason why the content rate of the group 3A element in the total amount of the sintering material is limited to 0.05 mass% or more and 5 mass% or less in oxide equivalent is as follows.

In detail, if the content rate of the group 3A element is less than the aforementioned range, the viscosity of a liquid phase will be too low, and it will become difficult for the liquid phase component to remain in the grain boundary, and the movement of a sintering assistant will be obstructed during HIP treatment, and therefore it is impossible to obtain an effect by which a sintered body is densified by rearranging crystal grains that form the sintered body, and pores that are present inside the sintered body are filled or are reduced in diameter.

Therefore, voids exposed on the bonding surface of the AlN substrate that has been polished exceed the range determined in the present invention, and become large.

On the other hand, if it exceeds the aforementioned range, the viscosity of the liquid phase will become too high so as to obstruct sintering, and therefore there is a fear that the thermal conductivity of an AlN substrate produced through each step mentioned above will not be maintained within the suitable range of thermal conductivity required of the AlN substrate, particularly within the range of 80 W/m·K or more described above.

Preferably, at least one selected from the group consisting of Y and lanthanoids is used as the group 3A element in consideration of, for example, the effect of adjusting the viscosity of the liquid phase, and, particularly, it is preferable to use Yb and Nd of the lanthanoids together or to use these two elements and Y together.

Preferably, Al that is not a component of AlN is additionally contained in the sintering material within a range of 0.05 mass% or more and 5 mass% or less in oxide equivalent of the total amount of the sintering material, in addition to each component mentioned above.

If the content rate of Al that is not a component of AlN is less than the aforementioned range, there is a fear that the amount of generation of a liquid phase will decrease, and sintering will not be advanced. On the other hand, if it exceeds the aforementioned range, there is a fear that the generation temperature of the liquidphase will rise, and crystal grains of AlN will coarsen. Additionally, a grain boundary phase is liable to segregate to the triple point of the AlN crystal grain, and, if this segregation occurs, the movement of the sintering assistant will be obstructed during HIP treatment, and therefore there is also a fear that it will be impossible to obtain an effect by which a sintered body is densified by rearranging crystal grains that form the sintered body, and pores that are present inside the sintered body are filled or are reduced in diameter.

An oxide that is present on the surface of AlN particles used as rawmaterial is also regarded as being included in an oxide of Al that is not a component of AlN. The amount of an oxide included in AlN used as raw material is calculated beforehand, and, if the amount of the oxide is below a predetermined value in the aforementioned range, it is recommended to add the oxide of Al and set the additional amount so that the total amount of the oxide reaches the predetermined value.

Preferably, the oxide conversion weight x of the group 2A element and the oxide conversion weight y of Al that is not a component of AlN among each component mentioned above are adjusted to satisfy formula (1):

$$0.05 \leq x/(x+y) \leq 0.35 \qquad (1)$$

Additionally, preferably, the oxide conversion weight z of the group 3A element and the oxide conversion weight y of Al that is not a component of AlN are adjusted to satisfy formula (2) :

$$0.20 \leq y/(z+y) \leq 0.60 \qquad (2)$$

Those are adjusted to fall within the range satisfying formulas (1) and (2), and, as a result, it is possible to maintain a balance among the aforementioned functions of the group 2A element, the group 3A element, and Al that is not a component of AlN.

Si may be contained in the sintering material in order to heighten the bondability with respect to a semiconductor substrate or the like according to, for example, the direct bonding method. However, if a large amount of Si is contained therein, there is a fear that complex oxide SiAlON crystals will be generated, and the shedding of grains will occur at, for example, a polishing step after completing HIP treatment. Therefore, it is preferable not to contain Si therein, and, even if it is contained therein, it is preferable to set the rate to be 1 mass% or less of the total amount of the sintering material in oxide equivalent.

Each component other than AlN can be mixed with AlN in a state of a compound, such as oxide, nitride, carbide, carbonate, or complex oxide. If a compound other than the oxide is used, it is recommended to adjust the amount of the compound to be mixed so that the content rate of the group 2A element or the like contained in the compound falls within the aforementioned range in oxide equivalent.

Preferably, the mean particle diameter of powder of AlN among the components mentioned above is 0.1 μm or more and 3.0 μm or less. Preferably, the mean particle diameter of powder of the compound of the group 2A element is 0.2 μm or more and 5.0 μm or less. Preferably, the mean particle diameter of powder of the compound of the group 3A element is 0.2 μm or more and 4.0 μm or less. Preferably, the mean particle diameter of powder of the compound of Al that is not a component of AlN is 0.1 μm or more and 3.0 μm or less. Additionally, preferably, the mean particle diameter of powder of the compound of Si is 0.5 μm or more and 6.0 μm or less.

If the mean particle diameter of each component mentioned above is less than the aforementioned range, there is a fear that the powder will become bulky and will have difficulty in being evenly mixed, and necessary sintered density cannot be obtained. On the other hand, if the mean particle diameter exceeds the aforementioned range, each component will not be sufficiently pulverized at a blending step, and therefore there is a fear that the composition will become non-uniform, and a variation in density will occur after being sintered, or the shedding of grains will occur at, for example, the polishing step after completing HIP treatment, and the surface roughness will become high after processing.

(Preforming Step)

Slurry is prepared by additionally mixing a binder and a dispersive medium with the sintering material, and a green sheet is produced by molding the slurry in a sheet-like shape.

Both a binder using an organic solvent as a dispersive medium and a binder using water as a dispersive medium are usable as the aforementioned binder.

One kind or two kinds or more of binders, such as an acryl-based binder, a polyvinyl butyral-based binder, and a cellulose-based binder, can be mentioned as the binder using an organic solvent as a dispersive medium that is one of the aforementioned two. One kind or two kinds or more of, for example, various alcohols can be mentioned as the organic solvent.

One kind or two kinds or more of binders, such as a polyvinyl alcohol-based binder, an acryl-based binder, a urethane-based binder, and a vinyl acetate-based binder, can be mentioned as the binder using water as a dispersive medium.

For example, a dispersing agent or a plasticizer may be mixed with the slurry in order to improve the stability of the slurry, the dispersibility of the sintering material, or the flexibility of the green sheet.

To blend the slurry, both a dry blending method and a wet blending method can be employed by use of a general blender, such as a ball mill, an attritor, or a planetary mill. In the slurry blended according to the wet blending method, coarse grains may be sieved by use of, for example, a mesh whose hole diameter is about 1 μm.

For example, an extrusion method is employed as a molding method for molding the slurry in a sheet-like shape and producing a green sheet. The green sheet may be produced by piling up a plurality of thin sheets produced according to, for example, a doctor blade method.

Thereafter, the green sheet is dried, and, as a result, a preform is obtained.

Preferably, the temperature of drying is 0°C or more, particularly 15°C or more, and 80°C or less, particularly 50°C or less.

If the temperature is less than the aforementioned range, there is a fear that the volatilization rate of the dispersive medium from inside the green sheet will be too slow, and much time will be consumed for drying, and therefore the productivity of the AlN substrate will fall.

On the other hand, if it exceeds the aforementioned range, there is a fear that the volatilization rate of the dispersive medium from inside the green sheet will be too fast, and non-uniformity will easily occur in the degree of drying, and, in response thereto, wrinkles and warpage will easily be generated in the preform.

The period of time of drying is preferably one hour or more, more preferably ten hours or more, and particularly twenty hours or more.

If the period of time is less than the aforementioned range, there is a fear that drying will be insufficient, and cracks or the like will be liable to occur at a binder-removing step, which is a subsequent step, because of volatilization of the dispersive medium remaining in the preform.

Preferably, the period of time of drying is 48 hours or less in the aforementioned range in consideration of the productivity etc., of the AlN substrate.

(Binder-Removing Step)

Thereafter, the preform is heated to more than the thermal decomposition temperature of the binder, and the binder and other organic substances are removed, and, as a result, a precursor that is made of only a sintering material and that has not yet been sintered is produced.

The binder-removing processing may be performed in an oxidizing atmosphere, such as the air, in order to promote the thermal decomposition of the binder, or may be performed in an inert atmosphere such as a nitrogen atmosphere.

Preferably, if the binder-removing processing is performed in the air, the temperature is 400°C or more and 600°C or less.

If the temperature is less than the aforementioned range, there is a fear that the binder cannot be removed sufficiently, and sintering will be obstructed by the binder remaining in the precursor at a sintering step, which is a subsequent step, and the binder will be gasified so that cracks occur in the sintered body.

On the other hand, if it exceeds the aforementioned range, there is a fear that sintering will be obstructed by surface oxidation.

Preferably, if the binder-removing processing is performed in a nitrogen atmosphere, the temperature is 500°C or more and 900°C or less.

If the temperature is less than the aforementioned range, there is a fear that the binder cannot be removed sufficiently, and sintering will be obstructed by the binder remaining in the precursor at the sintering step, which is a subsequent step, and the binder will be gasified so that cracks occur in the sintered body.

On the other hand, even if it exceeds the aforementioned range, there is a fear that the fact that energy required for heating becomes excessive, and, as a result, the productivity of the AlN substrate falls will occur in addition to the fact that a further effect cannot be obtained.

Preferably, the period of time of the binder-removing processing is one hour or more and ten hours or less when the binder-removing processing is performed in any atmosphere.

If the period of time is less than the aforementioned range, there is a fear that the binder cannot be removed sufficiently, and sintering will be obstructed by the binder remaining in the precursor at the sintering step, which is a subsequent step, and the binder will be gasified so that cracks occur in the sintered body.

On the other hand, even if it exceeds the aforementioned range, there is a fear that the fact that energy required for heating becomes excessive, and, as a result, the productivity of the AlN substrate falls will occur in addition to the fact that a further effect cannot be obtained.

(Sintering Step)

Thereafter, the precursor is sintered at a temperature of 1500°C or more and 1900°C or less in an inert atmosphere, such as a nitrogen atmosphere, and a sintered body is formed.

The reason why the temperature of sintering is limited to 1500°C or more and 1900°C or less is as follows.

In detail, if the temperature is less than the aforementioned range, sintering will be insufficient, and pores that are present inside the sintered body will be too large, and therefore, at a HIP treatment step that is a subsequent step, it is impossible to obtain an effect by which a sintered body is densified by rearranging crystal grains that form the sintered body, and pores that are present inside the sintered body are filled or are reduced in diameter.

On the other hand, if it exceeds the aforementioned range, sintering will be excessively advanced, and the movement of a sintering assistant will be obstructed during HIP treatment, and therefore it is impossible to obtain an effect by which a sintered body is densified by rearranging crystal grains that form the sintered body, and pores that are present inside the sintered body are filled or are reduced in diameter.

Preferably, the temperature of sintering is 1600°C or more and 1750°C or less in the aforementioned range in consideration of densifying the sintered body even more excellently and filling or reducing pores that are present inside the sintered body in diameter at the HIP treatment step that is a subsequent step.

Additionally, preferably, the period of time of sintering is one hour or more and ten hours or less.

If the period of time is less than the aforementioned range, the period of time required for the rearrangement or for the combination of crystal grains at the sintering step is short, and therefore there is a fear that a variation in density will become large in the sintered body, and the pores can only partially be filled or reduced in diameter even if HIP treatment is performed at the subsequent step.

On the other hand, if it exceeds the aforementioned range, there is a fear that sintering will be excessively advanced, and a sintering assistant will be liable to segregate to the surface, and, if this segregation occurs, the movement of the sintering assistant will be obstructed during HIP treatment, and therefore it is impossible to obtain an effect by which a sintered body is densified by rearranging crystal grains that form the sintered body, and pores that are present inside the sintered body are filled or are reduced in diameter.

Preferably, the pressure during sintering is one atmospheric pressure (=1013.25 hPa) or more and ten atmospheric pressures (=10132.5 hPa) or less.

If the pressure is less than the aforementioned range, there is a fear that AlN will be decomposed, and if it exceeds the aforementioned range, there is a fear that a sintering assistant will be liable to segregate in a sintered body, and, if this segregation occurs, the movement of the sintering assistant will be obstructed during HIP treatment, and therefore it is impossible to obtain an effect by which a sintered body is dens if ied by rearranging crystal grains that form the sintered body, and pores that are present inside the sintered body are filled or are reduced in diameter.

(Hip Treatment Step)

Thereafter, the sintered body is subjected to HIP treatment in an inert atmosphere, such as a nitrogen atmosphere or an argon atmosphere, at a temperature of 1450°C or more and 2000°C or less and under a pressure of 9.8 MPa or more.

The reason why the temperature of HIP treatment is limited to 1450°C or more and 2000°C or less is as follows.

In detail, if the temperature is less than the aforementioned range, the generation of a liquid phase by a reaction between a sintering assistant and an oxide on the surface of AlN particles as described above is not advanced, and therefore there is a fear that it will be impossible to obtain an effect by which a sintered body is densified by rearranging crystal grains that form the sintered body, and pores that are present inside the sintered body are filled or are reduced in diameter, which is generated by the flow of the liquid phase. Therefore, there is also a fear that the surface roughness Ra will exceed 15 nm.

On the other hand, if it exceeds the aforementioned range, it will become difficult to generate the rearrangement of crystal grains because the growth reaction of the crystal grains predominates, and therefore there is a fear that it will be impossible to obtain an effect by which a sintered body is densified by the rearrangement, and pores that are present inside the sintered body are filled or are reduced in diameter. Therefore, there is also a fear that the surface roughness Ra will exceed 15 nm.

Preferably, the temperature is 1600°C or more and 1900°C or less in consideration of densifying the sintered body even more excellently and filling or reducing pores that are present inside the sintered body in diameter at the HIP treatment step.

The reason why the pressure of HIP treatment is limited to 9.8 MPa or more is as follows.

In detail, if the pressure is less than the aforementioned range, it will be impossible to obtain an effect by which a sintered body is densified by rearranging crystal grains that form the sintered body, and pores that are present inside the sintered body are filled or are reduced in diameter.

Preferably, the pressure is 196 MPa or less in the aforementioned range.

Even if it exceeds the aforementioned range, there is a fear that the fact that energy required for the HIP treatment becomes excessive, and, as a result, the productivity of the AlN substrate falls will occur in addition to the fact that a further effect cannot be obtained.

Additionally, preferably, the period of time of the HIP treatment is one hour or more and ten hours or less.

If the period of time is less than the aforementioned range, the movement of the sintering assistant will not be performed sufficiently even if a liquid phase is generated, and therefore there is a fear that it will be impossible to satisfactorily obtain an effect by which a sintered body is densified by rearranging crystal grains, and pores that are present inside the sintered body are filled or are reduced in diameter.

On the other hand, even if it exceeds the aforementioned range, there is a fear that the fact that energy required for the HIP treatment becomes excessive, and, as a result, the productivity of the AlN substrate falls will occur in addition to the fact that a further effect cannot be obtained.

(Polishing Step)

The bonding surface, which is bonded to another member, of the AlN substrate that has undergone the HIP treatment is subj ected to, for example, mirror polishing as described above, and is finished so that the surface roughness Ra is 15 nm or less, and the mean value of the long diameters of voids that are exposed on the bonding surface and each of which has a long diameter of 0.25 $\mu$m or more is 1.5$\mu$m or less, and the maximum value thereof is 1. 8 $\mu$m or less, and, asaresult, the AlN substrate can be used as, for example, a base substrate of a laminated substrate.

Various polishing methods, such as machine polishing of, for example, lap processing by loose grains and fixed grains or chemical mechanical polishing, can be employed as the polishing method.

(Heat Treatment Step)

After completing the HIP treatment, the AlN substrate that has not yet been polished may be subj ected to heat treatment in an inert atmosphere, such as a nitrogen atmosphere or an argon atmosphere, while being pressed in the thickness direction if necessary. The warpage of the AlN substrate can be corrected by performing this heat treatment.

Preferably, the temperature of heat treatment is 1500°C or more and 1900°C or less. If the temperature of heat treatment is less than the aforementioned range, there is a fear that the warpage correcting effect cannot be satisfactorily obtained. Even if it exceeds the aforementioned range, a further effect cannot be obtained, and it is unreasonable.

Preferably, the period of time of heat treatment is 0.5 hours or more and 5 hours or less. If the period of time of heat treatment is less than the aforementioned range, there is a fear that the warpage correcting effect cannot be satisfactorily obtained. Even if it exceeds the aforementioned range, a further effect cannot be obtained, and it is unreasonable.

Preferably, the pressure applied in the thickness direction is 150 Pa or more and 1000 Pa or less in surf ace pressure. If the pressure is less than the aforementioned range, there is a fear that the warpage correcting effect cannot be satisfactorily obtained. Even if it exceeds the aforementioned range, a further effect cannot be obtained, and it is unreasonable.

Preferably, the warpage of the AlN substrate is within $\pm 0.7$ $\mu$m/1 mm, particularly within $\pm 0.3$ $\mu$m/1 mm in terms of the maximum amount of displacement in a direction perpendicular to the bonding surface per millimeter in length on the bonding surface of the AlN substrate.

Examples

<Example 1>

(Preparation for Sintering material)

Powder of each component mentioned below was prepared as the sintering material.

AlN: Mean particle diameter 0.9 $\mu$m, Oxygen content 0.8 mass%
$CaCO_3$: Mean particle diameter 6 $\mu$m
$Yb_2O_3$: Mean particle diameter 1.2 $\mu$m
$Nd_2O_3$: Mean particle diameter 3.5 $\mu$m
$Al_2O_3$: Mean particle diameter 0.3 $\mu$m
$SiO_2$: Mean particle diameter 3.8 $\mu$m

(Preparation of Slurry and Fabrication of Preform)

Powders of the respective components mentioned above are mixed together so that the content rates in the total amount of the sintering material are set as follows (note that this mixture is referred to as "Composition A"), and a slurry was prepared by mixing the dispersive medium and the binder together.

AlN: 96.8 mass%,
Ca as the group 2A element (in oxide equivalent): 0.1 mass%,
Yb as the group 3A element (in oxide equivalent): 1.1 mass%,
Nd as the group 3A element (in oxide equivalent): 1.0 mass%,
Al that is not a component of AlN (in oxide equivalent) : 0.8 mass%,
Si (in oxide equivalent): 0.2 mass%

Thereafter, the slurry was molded in a sheet-like shape of 260 mm in length $\times$ 260 mm in width $\times$ 1.2 mm in thickness according to the extrusion method, and, as a result, a green sheet was produced, and this green sheet was naturally dried under the conditions of temperature: $24\pm4°C$ and period of time: 24 hours, and, as a result, a preform was produced. (Binder-Removing Step)

The preform was placed on a jig made of boron nitride, and was subjected to binder-removing processing in the air under the conditions of temperature: 500°C and period of time: 5 hours, and, as a result, a precursor that has not yet been sintered and that is made of only the sintering material was produced.

(Sintering Step)

The precursor was sintered in a nitrogen atmosphere under the conditions of temperature: 1650°C, period of time: 5 hours, and pressure: 1 atmospheric pressure, and, as a result, a sintered body was produced.

(Hip Treatment Step to Polishing Step)

The sintered body was subjected to HIP treatment in a nitrogen atmosphere under the conditions of temperature:

1790°C, period of time: 1 hour, and pressure: 98MPa, and then its external shape was formed by lap processing by loose grains, and its bonding surface was subjected to mirror polishing, and, as a result, a disk-shaped AlN substrate of $\varphi$200×0.7 mm t was produced. The warpage of the AlN substrate was 0.8 $\mu$m/mm.

<Examples 2 to 6, Comparative examples 1 and 2>

An AlN substrate was produced in the same way as in Example 1 except that the temperature of sintering at the sintering step was 1480°C (Comparative example 1), 1500°C (Example 2), 1600°C (Example 3), 1750°C (Example 4), 1850°C (Example 5), 1900°C (Example 6), and 1920°C (Comparative example 2).

<Examples 7 and 8>

An AlN substrate was produced in the same way as in Example 1 except that the period of time of sintering at the sintering step was 1 hour (Example 7) and 10 hours (Example 8).

<Measurement of Surface Roughness Ra>

Arithmetic mean heights Ra were found from contour curves of surface roughness measured by the field of view of 0. 6 mm×0.5 mm by use of a non-contact type surface roughness meter at five arbitrary places on the bonding surface, which is one side of a disk, of the AlN substrate produced in each example and each comparative example mentioned above, and then the mean value thereof was calculated, and was determined as surface roughness Ra of the bonding surface of the AlN substrate of each example and each comparative example.

<Measurement of Long Diameters of Voids>

As described above, carbon was vapor-deposited onto the bonding surface, which is one side of a disk, of the AlN substrate produced in each example and each comparative example, and five arbitrary fields of view were photographed at 1000-fold magnification by use of a scanning electron microscope.
Thereafter, a photographed image was enlarged three times, and all voids confirmed in the field of view were subjected to ellipse approximation, and its long axis was measured as a long diameter, and voids having a long diameter less than 0.25 $\mu$m were excluded. From measurement values of the long diameters of all voids having a long diameter of 0.25 $\mu$m or more, the mean value and the maximum value of the long diameters were found.

<Measurement of Thermal Conductivity>

The thermal conductivity in the thickness direction of an AlN substrate produced in each example and each comparative example was measured according to a laser flash method.

<Measurement of Thermal Expansion Coefficient>

The thermal expansion coefficient in the surface direction of an AlN substrate produced in each example and each comparative example was measured by use of a differential dilatometer.

<Composition Analysis>

The bonding surface, which is one side of a disk and which has undergone mirror polishing, of an AlN substrate produced in each example and each comparative example was analyzed by glow discharge mass spectrometry (GDMS), and from analysis results, the percentage (mass%) of group 2A elements and group 3A elements contained in the AlN substrate was calculated in terms of oxide equivalent.
These results are shown in Table 1 and Table 2.

[Table 1]

| | Raw material composition | Sintering step | | HIP treatment step | |
|---|---|---|---|---|---|
| | | Temperature (°C) | Period of time (hr) | Temperature (°C) | Pressure (MPa) |
| Comparative example 1 | A | 1480 | 5 | 1790 | 98 |
| Example 2 | A | 1500 | 5 | 1790 | 98 |
| Example 3 | A | 1600 | 5 | 1790 | 98 |
| Example 1 | A | 1650 | 5 | 1790 | 98 |
| Example 4 | A | 1750 | 5 | 1790 | 98 |
| Example 5 | A | 1850 | 5 | 1790 | 98 |
| Example 6 | A | 1900 | 5 | 1790 | 98 |
| Comparative example 2 | A | 1920 | 5 | 1790 | 98 |
| Example 7 | A | 1650 | 1 | 1790 | 98 |
| Example 8 | A | 1650 | 10 | 1790 | 98 |

[Table 2]

Table 2

| Evaluation | Surface roughness Ra (nm) | Long diameter of void ($\mu$m) | | Thermal conductivity (W/m·K) | Thermal expansion coefficient ($\times 10^{-6}$/°C) | Percentage of group 2A and 3A elements (in oxide equivalent, mass%) | | |
|---|---|---|---|---|---|---|---|---|
| | | Mean value | Maximum value | | | CaO | $Yb_2O_3$ | $Nd_2O_3$ |
| Comparative example 1 | 2.8 | 1.6 | 1.8 | 85 | 4.5 | 0.10 | 1.08 | 0.98 |
| Example 2 | 2.8 | 1.4 | 1.7 | 90 | 4.5 | 0.10 | 1.08 | 0.98 |
| Example 3 | 0.6 | 0.7 | 1.0 | 97 | 4.5 | 0.09 | 0.96 | 0.86 |
| Example 1 | 0.6 | 0.6 | 0.9 | 98 | 4.5 | 0.09 | 0.85 | 0.72 |
| Example 4 | 0.8 | 0.8 | 1.0 | 105 | 4.5 | 0.08 | 0.82 | 0.68 |
| Example 5 | 1.2 | 1.2 | 1.5 | 110 | 4.5 | 0.07 | 0.76 | 0.62 |
| Example 6 | 1.6 | 1.5 | 1.7 | 108 | 4.5 | 0.03 | 0.61 | 0.45 |
| Comparative example 2 | 3.0 | 1.8 | 2.1 | 120 | 4.5 | 0.01 | 0.48 | 0.36 |
| Example 7 | 0.5 | 1.0 | 1.2 | 90 | 4.5 | 0.09 | 0.88 | 0.74 |
| Example 8 | 0.8 | 0.6 | 1.1 | 103 | 4.5 | 0.08 | 0.84 | 0.70 |

From results of Examples 1 to 6 and Comparative examples 1 and 2 of Table 1 and Table 2, it has been understood that, when an AlN substrate is produced through the sintering step and the HIP treatment step by use of a sintering material in which the content rates of AlN, the group 2A element, and the group 3A element respectively fall within the ranges determined in the present invention, the temperature of sintering at the sintering step is required to be set at 1500°C or more and 1900°C or less in order to set the surface roughness Ra of the bonding surface of a produced AlN substrate and the mean value and the maximum value of the long diameters of voids so as to respectively fall within the ranges determined in the present invention.

Additionally, from results of Examples 1 to 6, it has been understood that it is preferable to set the temperature of sintering at 1600°C or more and 1750°C or less in the aforementioned range in order to make the surface roughness Ra of the bonding surface and the mean value and the maximum value of the long diameters of voids as small as possible in the aforementioned ranges.

Additionally, from results of Examples 1, 7, and 8, it has been understood that it is preferable to set the period of time of sintering at 1 to 10 hours at the sintering step.

<Examples 9 to 13, Comparative examples 3 and 4>

An AlN substrate was produced in the same way as in Example 1 except that the temperature of HIP treatment was 1430°C (Comparative example 3), 1450°C (Example 9), 1600°C (Example 10), 1700°C (Example 11), 1900°C (Example 12), 2000°C (Example 13), and 2030°C (Comparative example 4).

<Examples 14 and 15, Comparative example 5>

An AlN substrate was produced in the same way as in Example 1 except that the pressure of HIP treatment was 8.5 MPa (Comparative example 5), 9.8 MPa (Example 14), and 196 MPa (Example 15).

<Comparative examples 6 to 8>

An AlN substrate was produced in the same way as in Example 1 except that the HIP treatment step was excluded, and the temperature of sintering was 1500°C (Comparative example 6), 1650°C (Comparative example 7), and 1900°C (Comparative example 8) at the sintering step.

<Comparative example 9>

An AlN substrate was produced in the same way as in Example 1 except that the HIP treatment step was excluded, and the sintering step was performed at the following two stages (A) and (B).

(A) Temperature: 1650°C, Period of time : 5 hours, Pressure: 1 atmospheric pressure
(B) Temperature: 1790°C, Period of time: 1 hour, Pressure: 1 atmospheric pressure

AlN substrates produced in each example and each comparative example mentioned above underwent the aforementioned evaluation test, and characteristics thereof were evaluated. Results are shown in Table 3 and Table 4 along with results of Example 1.

[Table 3]

Table 3

| | Raw material composition | Sintering step | | HIP treatment step | |
|---|---|---|---|---|---|
| | | Temperature (°C) | Period of time (hr) | Temperature (°C) | Pressure (MPa) |
| Comparative example 3 | A | 1650 | 5 | 1430 | 98 |
| Example 9 | A | 1650 | 5 | 1450 | 98 |
| Example 10 | A | 1650 | 5 | 1600 | 98 |
| Example 11 | A | 1650 | 5 | 1700 | 98 |
| Example 1 | A | 1650 | 5 | 1790 | 98 |
| Example 12 | A | 1650 | 5 | 1900 | 98 |
| Example 13 | A | 1650 | 5 | 2000 | 98 |
| Comparative example 4 | A | 1650 | 5 | 2030 | 98 |
| Comparative example 5 | A | 1650 | 5 | 1790 | 8.5 |

(continued)

|  | Raw material composition | Sintering step | | HIP treatment step | |
|---|---|---|---|---|---|
|  |  | Temperature (°C) | Period of time (hr) | Temperature (°C) | Pressure (MPa) |
| Example 14 | A | 1650 | 5 | 1790 | 9.8 |
| Example 15 | A | 1650 | 5 | 1790 | 196 |
| Comparative example 6 | A | 1500 | 5 | - | - |
| Comparative example 7 | A | 1650 | 5 | - | - |
| Comparative example 8 | A | 1900 | 5 | - | - |
| Comparative example 9 | A | Two stages | | - | - |

[Table 4]

Table 4

| Evaluation | Surface roughness Ra (nm) | Long diameter of void ($\mu$m) | | Thermal conductivity (W/m·K) | Thermal expansion coefficient ($\times10^{-6}$/°C) | Percentage of group 2A and 3A elements (in oxide equivalent, mass%) | | |
|---|---|---|---|---|---|---|---|---|
|  |  | Mean value | Maximum value |  |  | CaO | $Yb_2O_3$ | $Nd_2O_3$ |
| Comparative example 3 | 2.2 | 4.2 | 5.1 | 80 | 4.3 | 0.09 | 0.87 | 0.73 |
| Example 9 | 0.7 | 1.2 | 1.4 | 90 | 4.5 | 0.09 | 0.87 | 0.73 |
| Example 10 | 0.5 | 0.8 | 1.1 | 100 | 4.5 | 0.09 | 0.84 | 0.73 |
| Example 11 | 0.6 | 0.7 | 1.0 | 105 | 4.5 | 0.08 | 0.82 | 0.72 |
| Example 1 | 0.6 | 0.6 | 0.9 | 98 | 4.5 | 0.09 | 0.85 | 0.72 |
| Example 12 | 1.4 | 1.0 | 1.2 | 125 | 4.5 | 0.07 | 0.80 | 0.68 |
| Example 13 | 1.5 | 1.4 | 1.7 | 130 | 4.5 | 0.07 | 0.78 | 0.65 |
| Comparative example 4 | 1.5 | 1.7 | 1.9 | 128 | 4.5 | 0.06 | 0.72 | 0.59 |
| Comparative example 5 | 0.8 | 1.1 | 2.3 | 92 | 4.5 | 0.08 | 0.81 | 0.68 |
| Example 14 | 0.6 | 0.9 | 1.1 | 95 | 4.5 | 0.08 | 0.80 | 0.71 |
| Example 15 | 0.6 | 0.5 | 0.9 | 100 | 4.5 | 0.09 | 0.86 | 0.73 |
| Comparative example 6 | 32 | 12 | 32 | 80 | 4.2 | 0.09 | 1.05 | 0.78 |
| Comparative example 7 | 24 | 7.5 | 15 | 85 | 4.3 | 0.09 | 0.88 | 0.73 |
| Comparative example 8 | 16 | 5.3 | 12 | 90 | 4.3 | 0.01 | 0.52 | 0.39 |
| Comparative example 9 | 19 | 6.2 | 13 | 88 | 4.3 | 0.06 | 0.64 | 0.45 |

From results of Examples 1, 9 to 13 and Comparative examples 6 to 9 of Table 3 and Table 4, it has been understood that, when an AlN substrate is produced by use of a sintering material in which the content rates of AlN, the group 2A element, and the group 3A element respectively fall within the ranges determined in the present invention, satisfaction cannot be obtained only by changing the temperature of sintering or performing the sintering process at two stages without performing the HIP treatment step, and therefore the HIP treatment step is required to be performed after the sintering step in order to set the surface roughness Ra of the bonding surface of a produced AlN substrate and the mean value and the maximum value of the long diameters of voids so as to respectively fall within the ranges determined in the present invention.

Additionally, from results of Examples 1, 9 to 13 and Comparative examples 3 and 4, it has been understood that, when an AlN substrate is produced through the sintering step and the HIP treatment step by use of the sintering material, the temperature of the HIP treatment is required to be set at 1450°C or more and 2000°C or less in order to set the surface roughness Ra of the bonding surface of a produced AlN substrate and the mean value and the maximum value of the long diameters of voids so as to respectively fall within the ranges determined in the present invention.

Additionally, from results of Examples 1, 9 to 13, it has been understood that it is preferable to set the temperature of the HIP treatment at 1600°C or more and 1900°C or less in the aforementioned range in order to make the surface roughness Ra of the bonding surface and the mean value and the maximum value of the long diameters of voids as small as possible in the aforementioned ranges.

Additionally, from results of Examples 1, 14, 15 and Comparative example 5, it has been understood that, when an AlN substrate is produced through the sintering step and the HIP treatment step by use of the sintering material, the pressure of the HIP treatment is required to be set at 9.8 MPa or more in order to set the surface roughness Ra of the bonding surface of a produced AlN substrate and the mean value and the maximum value of the long diameters of voids so as to respectively fall within the ranges determined in the present invention.

<Examples 16, 17, Comparative example 10>

An AlN substrate was produced in the same way as in Example 1 except that the sintering material of Composition B (Example 16), that of Composition C (Example 17), and that of Composition D (Comparative example 10) shown in Table 5 were used instead of the sintering material of Composition A.

[Table 5]

Table 5

| Composition | Mass% (in oxide equivalent excluding AlN) | | | | | | |
| --- | --- | --- | --- | --- | --- | --- | --- |
| | AlN | Group 2A element | Group 3A element | | | Al that is not a component of AlN | Si |
| | | Ca | Y | Yb | Nd | | |
| A | 96.8 | 0.1 | - | 1.1 | 1.0 | 0.8 | 0.2 |
| B | 88.7 | 0.3 | 1.5 | 1.5 | 2.0 | 5.0 | 1.0 |
| C | 98.5 | 0.05 | 0.5 | - | 0.4 | 0.6 | - |
| D | 99.0 | 0.01 | - | 0.05 | 0.04 | 0.8 | 0.1 |

AlN substrates produced in each example and each comparative example mentioned above underwent the aforementioned evaluation test, and characteristics thereof were evaluated. Results are shown in Table 6 and Table 7 along with results of Example 1.

[Table 6]

Table 6

| | Raw material composition | AlN (Mass%) | Sintering step | | HIP treatment step | |
| --- | --- | --- | --- | --- | --- | --- |
| | | | Temperature (°C) | Period of time (hr) | Temperature (°C) | Pressure (MPa) |
| Example 16 | B | 88.7 | 1650 | 5 | 1790 | 98 |
| Example 1 | A | 96.8 | 1650 | 5 | 1790 | 98 |
| Example 17 | C | 98.5 | 1650 | 5 | 1790 | 98 |

(continued)

| | Raw material composition | AlN (Mass%) | Sintering step | | HIP treatment step | |
|---|---|---|---|---|---|---|
| | | | Temperature (°C) | Period of time (hr) | Temperature (°C) | Pressure (MPa) |
| Comparative example 10 | D | 99.0 | 1650 | 5 | 1790 | 98 |

[Table 7]

Table 7

| Evaluation | Surface roughness Ra (nm) | Long diameter of void ($\mu$m) | | Thermal conductivity (W/m·K) | Thermal expansion coefficient ($\times 10^{-6}$/°C) | Percentage of group 2A and 3A elements (in oxide equivalent, mass%) | | | | |
|---|---|---|---|---|---|---|---|---|---|---|
| | | Mean value | Maximum value | | | CaO | $Y_2O_3$ | $Yb_2O_3$ | $Nd_2O_3$ | $Si_2$ |
| Example 16 | 0.8 | 0.8 | 1.0 | 85 | 4.4 | 0.28 | 1.41 | 1.38 | 1.70 | 0.30 |
| Example 1 | 0.6 | 0.6 | 0.9 | 98 | 4.5 | 0.09 | - | 0.85 | 0.72 | 0.08 |
| Example 17 | 1.3 | 1.0 | 1.2 | 175 | 4.6 | 0.06 | 0.45 | - | 0.26 | - |
| Comparative example 10 | 8.6 | 4.6 | 9.6 | 200 | 4.4 | 0.009 | - | 0.02 | 0.03 | 0.03 |

From results of Examples 1, 16, 17 and Comparative example 10 of Table 6 and Table 7, it has been understood that the content rate of AlN is required to be set at 88.7 mass% or more and 98.5 mass% or less of the total amount of the sintering material in order to set the surface roughness Ra of the bonding surface of a produced AlN substrate and the mean value and the maximum value of the long diameters of voids so as to respectively fall within the ranges determined in the present invention.

<Examples 18, 19, Comparative examples 11, 12>

An AlN substrate was produced in the same way as in Example 1 except that the sintering material of Composition E (Example 18), that of Composition F (Example 19), that of Composition G (Comparative example 11), and that of Composition H (Comparative example 12) shown in Table 8 were used instead of the sintering material of Composition A.
[Table 8]

Table 8

| Composition | Mass% (in oxide equivalent excluding AlN) | | | | | | |
|---|---|---|---|---|---|---|---|
| | AlN | Group 2A element | Group 3A element | | | Al that is not a component of A1N | Si |
| | | Ca | Y | Yb | Nd | | |
| E | 95.0 | 0.01 | 1.19 | 1.2 | 1.5 | 0.8 | 0.3 |
| F | 95.0 | 0.3 | 0.6 | 1.0 | 1.0 | 1.8 | 0.3 |
| G | 95.0 | 0.005 | 0.6 | 1.5 | 1.5 | 1.1 | 0.295 |
| H | 95.0 | 0.4 | 0.6 | 1.0 | 1.0 | 1.5 | 0.3 |

AlN substrates produced in each example and each comparative example mentioned above underwent the aforementioned evaluation test, and characteristics thereof were evaluated. Results are shown in Table 9 and Table 10 along with results of Example 1.
[Table 9]

Table 9

| | Raw material composition | Group 2A element (Mass%) | Sintering step | | HIP treatment step | |
|---|---|---|---|---|---|---|
| | | | Temperature (°C) | Period of time (hr) | Temperature (°C) | Pressure (MPa) |
| Comparative example 11 | G | 0.005 | 1650 | 5 | 1790 | 98 |
| Example 18 | E | 0.01 | 1650 | 5 | 1790 | 98 |
| Example 1 | A | 0.1 | 1650 | 5 | 1790 | 98 |
| Example 19 | F | 0.3 | 1650 | 5 | 1790 | 98 |
| Comparative example 12 | H | 0.4 | 1650 | 5 | 1790 | 98 |

[Table 10]

Table 10

| Evaluation | Surface roughness Ra (nm) | Long diameter of void (μm) | | Thermal conductivity (W/m·K) | Thermal expansion coefficient ($\times 10^{-6}$/°C) | Percentage of group 2A and 3A elements (in oxide equivalent, mass%) | | | | |
|---|---|---|---|---|---|---|---|---|---|---|
| | | Mean value | Maximum value | | | CaO | $Y_2O_3$ | $Yb_2O_3$ | $Nd_2O_3$ | $Si_2$ |
| Comparative example 11 | 11 | 5.2 | 10.2 | 180 | 4.3 | 0.003 | 0.35 | 1.11 | 0.97 | 0.093 |
| Example 18 | 1.2 | 0.9 | 1.1 | 210 | 4.3 | 0.009 | 0.89 | 1.09 | 0.95 | 0.095 |
| Example 1 | 0.6 | 0.6 | 0.9 | 98 | 4.5 | 0.090 | - | 0.85 | 0.72 | 0.08 |
| Example 19 | 0.8 | 0.7 | 0.9 | 165 | 4.3 | 0.280 | 0.44 | 0.74 | 0.65 | 0.094 |
| Comparative example 12 | 23 | 4.7 | 6.8 | 185 | 4.6 | 0.380 | 0.42 | 0.76 | 0.64 | 0.094 |

From results of Examples 1, 18, 19 and Comparative examples 11, 12 of Table 9 and Table 10, it has been understood that the content rate of the group 2A element is required to be set at 0.01 mass% or more and 0.3 mass% or less in oxide equivalent of the total amount of the sintering material in order to set the surface roughness Ra of the bonding surface of a produced AlN substrate and the mean value and the maximum value of the long diameters of voids so as to respectively fall within the ranges determined in the present invention.

<Examples 20 to 22, Comparative examples 13, 14>

An AlN substrate was produced in the same way as in Example 1 except that the sintering material of Composition J (Example 20), that of Composition K (Example 21), that of Composition L (Example 22), that of Composition M (Comparative example 13), and that of Composition N (Comparative example 14) shown in Table 11 were used instead of the sintering material of Composition A.

[Table 11]

Table 11

| Composition | Mass% (in oxide equivalent excluding AlN) | | | | | | |
|---|---|---|---|---|---|---|---|
| | AlN | Group 2A element | Group 3A element | | | Al that is not a component of AlN | Si |
| | | Ca | Y | Yb | Nd | | |
| J | 98.5 | 0.3 | 0.05 | - | - | 0.85 | 0.3 |
| K | 95.8 | 0.2 | - | 0.5 | 0.5 | 3.0 | - |
| L | 93.0 | 0.2 | 1.0 | 2.0 | 2.0 | 1.3 | 0.5 |
| M | 95.1 | 0.2 | - | 0.03 | - | 3.87 | 0.8 |
| N | 92.8 | 0.2 | - | 3.0 | 3.0 | 0.9 | 0.1 |

AlN substrates produced in each example and each comparative example mentioned above underwent the aforementioned evaluation test, and characteristics thereof were evaluated. Results are shown in Table 12 and Table 13 along with results of Example 1.

[Table 12]

Table 12

| | Composition | Group 3A element (Mass%) | Sintering step | | HIP treatment step | |
|---|---|---|---|---|---|---|
| | | | Temperature (°C) | Period of time (hr) | Temperature (°C) | Pressure (MPa) |
| Comparative example 13 | M | 0.03 | 1650 | 5 | 1790 | 98 |
| Example 20 | J | 0.05 | 1650 | 5 | 1790 | 98 |
| Example 21 | K | 1.0 | 1650 | 5 | 1790 | 98 |
| Example 1 | A | 2.1 | 1650 | 5 | 1790 | 98 |
| Example 22 | L | 4.0 | 1650 | 5 | 1790 | 98 |
| Comparative example 14 | N | 6.0 | 1650 | 5 | 1790 | 98 |

[Table 13]

Table 13

| Evaluation | Surface roughness Ra (nm) | Long diameter of void ($\mu$m) | | Thermal conductivity (W/m·K) | Thermal expansion coefficient ($\times 10^{-6}$/°C) | Percentage of group 2A and 3A elements (in oxide equivalent, mass%) | | | | |
|---|---|---|---|---|---|---|---|---|---|---|
| | | Mean value | Maximum value | | | CaO | $Y_2O_3$ | $Yb_2O_3$ | $Nd_2O_3$ | $Si_2$ |
| Comparative example 13 | 0.8 | 2.2 | 3.2 | 186 | 4.5 | 0.18 | - | 0.014 | - | 0.25 |
| Example 20 | 1.4 | 0.9 | 1.2 | 215 | 4.6 | 0.28 | 0.02 | - | - | 0.09 |
| Example 21 | 0.7 | 0.7 | 0.9 | 193 | 4.3 | 0.17 | - | 0.37 | 0.32 | - |
| Example 1 | 0.6 | 0.6 | 0.9 | 98 | 4.5 | 0.09 | - | 0.85 | 0.72 | 0.08 |
| Example 22 | 0.7 | 0.8 | 0.9 | 186 | 4.2 | 0.17 | 0.92 | 1.80 | 1. 78 | 0.16 |
| Comparative example 14 | 1.3 | 1.6 | 2.1 | 75 | 4.3 | 0.18 | - | 2.72 | 2.54 | 0.03 |

From results of Examples 1, 20 to 22 and Comparative examples 13 and 14 of Table 12 and Table 13, it has been understood that the content rate of the total of the group 3A element is required to be set at 0.05 mass% or more and 5 mass% or less in oxide equivalent of the total amount of the sintering material in order to set the surface roughness Ra of the bonding surface of a produced AlN substrate and the mean value and the maximum value of the long diameters of voids so as to respectively fall within the ranges determined in the present invention.

<Example 23>

An AlN substrate was produced in the same way as in Example 1 except that the conditions of sintering at the sintering step were set at Temperature: 1500°C, Period of time: 5 hours, and Pressure: 1 atmospheric pressure in a nitrogen atmosphere, and the conditions of the HIP treatment were set at Temperature: 1450°C, Period of time : 1 hour, and Pressure 19.6 MPa in a nitrogen atmosphere.

<Examples 24 to 26, Comparative examples 15, 16>

An AlN substrate was produced in the same way as in Example 23 except that the temperature of the HIP treatment was 1440°C (Comparative example 15), 1650°C (Example 24), 1790°C (Example 25), 2000°C (Example 26), and 2015°C (Comparative example 16).

AlN substrates produced in each example and each comparative example mentioned above underwent the aforementioned evaluation test, and characteristics thereof were evaluated. Results are shown in Table 14 and Table 15.

[Table 14]

Table 14

| | Raw material composition | Sintering step | | HIP treatment step | |
|---|---|---|---|---|---|
| | | Temperature (°C) | Period of time (hr) | Temperature (°C) | Pressure (MPa) |
| Comparative example 15 | A | 1500 | 5 | 1440 | 19.6 |
| Example 23 | A | 1500 | 5 | 1450 | 19.6 |
| Example 24 | A | 1500 | 5 | 1650 | 19.6 |
| Example 25 | A | 1500 | 5 | 1790 | 19.6 |
| Example 26 | A | 1500 | 5 | 2000 | 19.6 |
| Comparative example 16 | A | 1500 | 5 | 2015 | 19.6 |

[Table 15]

Table 15

| Evaluation | Surface roughness Ra (nm) | Long diameter of void (μm) | | Thermal conductivity (W/m·K) | Thermal expansion coefficient ($\times 10^{-6}$/°C) | Percentage of group 2A and 3A elements (in oxide equivalent, mass%) | | |
|---|---|---|---|---|---|---|---|---|
| | | Mean value | Maximum value | | | CaO | $Yb_2O_3$ | $Nd_2O_3$ |
| Comparative example 15 | 15.6 | 1.5 | 1.8 | 85 | 4.4 | 0.09 | 1.08 | 0.69 |
| Example 23 | 13.4 | 1.3 | 1.6 | 90 | 4.5 | 0.09 | 1.08 | 0.69 |
| Example 24 | 8.4 | 0.8 | 1.0 | 90 | 4.5 | 0.09 | 0.86 | 0.72 |
| Example 25 | 0.6 | 0.8 | 1.0 | 90 | 4.5 | 0.09 | 0.84 | 0.71 |
| Example 26 | 9.5 | 1.2 | 1.5 | 90 | 4.5 | 0.06 | 0.78 | 0.65 |

(continued)

| Evaluation | Surface roughness Ra (nm) | Long diameter of void ($\mu$m) | | Thermal conductivity (W/m·K) | Thermal expansion coefficient ($\times 10^{-6}$/°C) | Percentage of group 2A and 3A elements (in oxide equivalent, mass%) | | |
|---|---|---|---|---|---|---|---|---|
| | | Mean value | Maximum value | | | CaO | Yb$_2$O$_3$ | Nd$_2$O$_3$ |
| Comparative example 16 | 16.2 | 1.8 | 2.5 | 95 | 4.4 | 0.06 | 0.70 | 0.58 |

From results of Examples 24 to 26 and Comparative examples 15 and 16 of Table 14 and Table 15, it has been confirmed that, in a series that differs in the temperature at the sintering step and in the pressure of HIP treatment, the temperature of the HIP treatment is required to be set at 1450°C or more and 2000°C or less in order to set the surface roughness Ra of the bonding surface of a produced AlN substrate and the mean value and the maximum value of the long diameters of voids so as to respectively fall within the ranges determined in the present invention in the same way as in the series of Examples 1, 9 to 13 and Comparative examples 3 and 4.

Additionally, from results of Examples 24 to 26 and Comparative examples 15 and 16, it has been understood that it is preferable to set the temperature of the HIP treatment at 1600°C or more and 1900°C or less in the aforementioned range in order to make the surface roughness Ra of the bonding surface and the mean value and the maximum value of the long diameters of voids as small as possible in the aforementioned ranges.

<Examples 27 to 30>

An AlN substrate was produced in the same way as in Example 1 except that both sides of the AlN substrate, which has been produced under the same conditions as in Example 1 and which has undergone HIP treatment and which has not yet been polished, were sandwiched between boron nitride plates, and were heat-treated for 2 hours at 1500°C (Example 27), at 1700°C (Example 28), at 1800°C (Example 29), and at 1900°C (Example 30) in a state in which a molybdenum plate was placed as a weight so that the surface pressure reaches 490 Pa, and thereafter the warpage ($\mu$m/1mm) of the AlN substrate was measured. Results are shown in Table 16 along with results of Example 1.

[Table 16]

Table 16

| | Raw material composition | Heat treatment | | Evaluation | | | | | | |
|---|---|---|---|---|---|---|---|---|---|---|
| | | Temperature (°C) | Period of time | Amount of warpage ($\mu$m/1mm) | Surface roughness Ra(nm) | Long diameter of void | | Percentage of group 2A and 3A elements (in oxide equivalent, mass%) | | |
| | | | | | | Mean value | Maximum value | CaO | $Yb_2O_3$ | $Nd_2O_3$ |
| Example 1 | A | - | - | 0.80 | 0.6 | 0.6 | 0.9 | 0.09 | 0.85 | 0.72 |
| Example 27 | A | 1500 | 2 | 0.65 | 0.6 | 0.6 | 0.9 | 0.09 | 0.85 | 0.72 |
| Example 28 | A | 1700 | 2 | 0.42 | 0.6 | 0.6 | 0.9 | 0.09 | 0.85 | 0.72 |
| Example 29 | A | 1800 | 2 | 0.30 | 0.6 | 0.7 | 1.0 | 0.08 | 0.82 | 0.72 |
| Example 30 | A | 1900 | 2 | 0.30 | 1.4 | 1.0 | 1.2 | 0.07 | 0.80 | 0.68 |

From results of Examples 27 to 30 of Table 16, it has been understood that the warpage of the AlN substrate can be efficiently corrected by heat-treating the AlN substrate that has undergone HIP treatment and that has not yet been polished at the temperature of 1500°C or more and 1900°C or less.

## Claims

1. An AlN substrate having a bonding surface to be bonded to another member, composed of a sintered body of AlN including a group 2A element at a rate of 0.009 mass% or more and 0.28 mass% or less in oxide equivalent and a group 3A element at a rate of 0.02 mass% or more and 4.5 mass% or less in oxide equivalent, a surface roughness Ra of the bonding surface is 15 nm or less, voids being exposed on the bonding surface and having long diameters of 0.25 $\mu$m or more, a mean value of the long diameters is 1.5 $\mu$m or less, and a maximum value of the long diameters is 1.8 $\mu$m or less.

2. The AlN substrate according to claim 1, wherein the group 2A element is at least one selected from the group consisting of Ca and Mg.

3. The AlN substrate according claim 1 or claim 2, wherein the group 3A element is at least one selected from the group consisting of Y and lanthanoids.

4. A method for producing the AlN substrate according to any one of claim 1 to claim 3, the method comprising:

   a step of forming a precursor of the AlN substrate by a sintering material that includes AlN being 88.7 mass% or more and 98.5 mass% or less, a group 2A element being 0.01 mass% or more and 0.3 mass% or less in oxide equivalent, and a group 3A element being 0.05 mass% or more and 5 mass% or less in oxide equivalent;
   a step of sintering the precursor at a temperature of 1500°C or more and 1900°C or less and, as a result, forming a sintered body;
   a step of applying hot isostatic processing onto the sintered body at a temperature of 1450°C or more and 2000°C or less and at a pressure of 9.8 MPa or more;
   a step of mirror polishing the bonding surface which is to be bonded to another member.

5. The method for producing the AlN substrate according to claim 4, wherein the sintering material additionally includes Al that is not a component of AlN within a range from 0.05 mass% or more to 5 mass% or less in oxide equivalent.

6. The method for producing the AlN substrate according to claim 4 or claim 5, wherein the sintering material does not include Si or, alternatively, includes Si within a range below 1 mass% in oxide equivalent.

## Patentansprüche

1. AlN-Substrat mit einer Bindungsoberfläche, die an ein anderes Element gebunden werden soll, zusammengesetzt aus einem Sinterkörper aus AlN, der ein Element der Gruppe 2A mit einem Anteil von 0,009 Masse-% oder mehr und 0,28 Masse-% oder weniger, bezogen auf das Oxid-Äquivalent, und ein Element der Gruppe 3A mit einem Anteil von 0,02 Masse-% oder mehr und 4,5 Masse-% oder weniger, bezogen auf das Oxid-Äquivalent, einschliesst, wobei die Oberflächenrauigkeit Ra der Bindungsoberfläche 15 nm oder weniger beträgt, Hohlräume auf der Bindungsoberfläche freiliegen, und lange Durchmesser von 0,25 $\mu$m oder mehr aufweisen, der Mittelwert der langen Durchmesser 1,5 $\mu$m oder weniger beträgt und der Maximalwert der langen Durchmesser 1,8 $\mu$m oder weniger beträgt.

2. AlN-Substrat gemäss Anspruch 1, wobei das Gruppe 2A-Element zumindest eines, ausgewählt aus der Gruppe bestehend aus Ca und Mg, ist.

3. AlN-Substrat gemäss Anspruch 1 oder Anspruch 2, wobei das Gruppe 3A-Element zumindest eines, ausgewählt aus der Gruppe bestehend aus Y und Lanthanoiden, ist.

4. Verfahren zur Herstellung des AlN-Substrats gemäss irgendeinem der Ansprüche 1 bis 3, wobei das Verfahren umfasst:

einen Schritt, in dem ein Vorläufer des AlN-Substrats durch ein Sintermaterial gebildet wird, das 88,7 Masse-% oder mehr und 98,5 Masse-% oder weniger AlN, 0,01 Masse-% oder mehr und 0,3 Masse-% oder weniger eines Gruppe 2A-Elements, bezogen auf das Oxid-Äquivalent, und 0,05 Masse-% oder mehr und 5 Masse-% oder weniger eines Gruppe 3A-Elements, bezogen auf das Oxid-Äquivalent, einschliesst;

einen Schritt, in dem der Vorläufer bei einer Temperatur von 1.500°C oder mehr und 1.900°C oder weniger gesintert wird und dadurch einen Sinterkörper bildet;

einen Schritt, in dem eine heissisotaktische Verarbeitung auf den Sinterkörper bei einer Temperatur von 1.450°C oder mehr und 2.000°C oder weniger und bei einem Druck von 9,8 MPa oder mehr angewendet wird;

einen Schritt, in dem die Bindungsoberfläche, die an ein anderes Element gebunden werden soll, hochglanzpoliert wird.

5. Verfahren zur Herstellung des AlN-Substrats gemäss Anspruch 4, wobei das Sintermaterial zusätzlich Al, das keine Komponente von AlN ist, innerhalb eines Bereichs von 0,05 Masse-% oder mehr bis 5 Masse-% oder weniger, bezogen auf das Oxid-Äquivalent, einschliesst.

6. Verfahren zur Herstellung des AlN-Substrats gemäss Anspruch 4 oder Anspruch 5, wobei das Sintermaterial kein Si einschliesst oder alternativ Si innerhalb eines Bereichs von unterhalb 1 Masse-%, bezogen auf das Oxid-Äquivalent, einschliesst.

## Revendications

1. Substrat d'AlN ayant une surface de liaison qui doit être liée à un autre élément, se composant d'un corps fritté d'AlN comprenant un élément du groupe 2A à un taux supérieur ou égal à 0,009 % en masse et inférieur ou égal à 0,28 % en masse en équivalent d'oxyde et un élément du groupe 3A à un taux supérieur ou égal à 0,02 % en masse et inférieur ou égal à 4,5 % en masse en équivalent d'oxyde, une rugosité de surface Ra de la surface de liaison est inférieure ou égale à 15 nm, des vides étant exposés sur la surface de liaison et ayant des diamètres longs supérieurs ou égaux à 0,25 $\mu$m, une valeur moyenne des diamètres longs inférieure ou égale à 1,5 $\mu$m et une valeur maximale des diamètres longs inférieure ou égale à 1,8 $\mu$m.

2. Substrat d'AlN selon la revendication 1, dans lequel l'élément du groupe 2A est au moins choisi dans le groupe constitué par Ca et Mg.

3. Substrat d'AlN selon la revendication 1 ou la revendication 2, dans lequel l'élément du groupe 3A est au moins un élément choisi dans le groupe constitué par Y et les lanthanides.

4. Procédé de production du substrat d'AlN selon l'une quelconque des revendications 1 à 3, le procédé comprenant :

une étape de formation d'un précurseur du substrat d'AlN par un matériau de frittage qui comprend de l'AlN à hauteur de 88,7 % en masse ou plus et 98,5 % en masse ou moins, un élément du groupe 2A à hauteur de 0,01 % en masse ou plus et 0,3 % en masse ou moins en équivalent d'oxyde, et un élément du groupe 3A à hauteur de 0,05 % en masse ou plus et de 5 % en masse ou moins en équivalent d'oxyde ;

une étape de frittage du précurseur à une température de 1500 °C ou plus et de 1900 °C ou moins et, en conséquence, de formation d'un corps fritté ;

une étape d'application d'un traitement isostatique chaud sur le corps fritté à une température de 1450 °C ou plus et de 2000 °C ou moins et à une pression de 9,8 MPa ou plus ;

une étape de polissage miroir de la surface de liaison qui doit être liée à un autre élément.

5. Procédé de production du substrat d'AlN selon la revendication 4, dans lequel le matériau de frittage comprend en outre de l'Al qui n'est pas un composant de l'AlN compris dans la plage allant de 0,05 % en masse ou plus à 5 % en masse ou moins en équivalent d'oxyde.

6. Procédé de production du substrat d'AlN selon la revendication 4 ou la revendication 5, dans lequel le matériau de frittage ne comprend pas de Si ou, en variante, comprend du Si dans une plage inférieure à 1 % en masse en équivalent d'oxyde.

## REFERENCES CITED IN THE DESCRIPTION

**Patent documents cited in the description**

- JP 2008300562 A
- JP 2006282500 A
- JP 2005001975 A
- US 4803183 A
- JP 2002293637 A